# DEMANDE DE BREVET EUROPEEN

(11) **EP 1 863 174 A1**
(43) Date de publication de la demande: **05.12.2007**
(21) Numéro de dépôt: 07109138.3
(22) Date de dépôt: 29.05.2007
(51) Int. Cl.: H03H 9/05

(54) **Composant contenant un filtre BAW**

(30) Priorité: 31.05.2006 FR 0651986
(71) Demandeur: ST MICROELECTRONICS S.A., 92120 Montrouge (FR); STMicroeletronics Crolles 2 SAS, 38920 Crolles (FR)
(72) Inventeur: MARTY, Michel, 38760, SAINT PAUL DE VARCES (FR); GIRAUDIN, Jean-Christophe, 38190, BERNIN (FR); CORONEL, Philippe, 38530, BARRAUX (FR)
(74) Mandataire: de Beaumont, Michel

(57) **Abrégé**

L'invention concerne un assemblage monolithique de composants électroniques comprenant un substrat semiconducteur (1), à un premier niveau au-dessus du substrat, au moins un résonateur à ondes acoustiques de volume (2-5), à un deuxième niveau au-dessus du résonateur, une couche semiconductrice mono-cristalline (23) dans laquelle sont formés des composants semiconducteurs, et des évidements (12, 13) sous les parties de la couche semiconductrice disposées au-dessus des résonateurs.

## Description

### Domaine de l'invention

La présente invention concerne le domaine des circuits intégrés et plus particulièrement un circuit intégré pouvant contenir un filtre ou résonateur à ondes acoustiques de volume, ces ondes acoustiques de volume étant couramment désignées dans la technique par le sigle d'origine anglo-saxonne BAW (Bulk Acoustic Waves).

### Exposé de l'art antérieur

La réalisation d'un circuit intégré contenant entre autres composants un résonateur à ondes acoustiques de surface ou de volume pose de nombreux problèmes de réalisation et de montage notamment du fait que les résonateurs à ondes acoustiques nécessitent des matériaux spécifiques (des matériaux piézoélectriques) non utilisés habituellement dans le domaine des circuits intégrés, et du fait qu'une surface, couramment la surface supérieure, d'un résonateur doit être laissée libre si on veut que le résonateur vibre convenablement. Dans certains dispositifs de l'art antérieur, le résonateur est placé du côté supérieur d'un composant et un espace est ménagé entre cette partie supérieure du résonateur et le boîtier, ce qui pose des problèmes de montage.

### Résumé de l'invention

La présente invention vise une nouvelle structure assemblant un résonateur ou une combinaison de résonateurs constituant un filtre à ondes acoustiques de volume et d'autres composants semiconducteurs d'une façon particulièrement simple et efficace, sans compliquer la fabrication des composants semiconducteurs classiques, et sans affecter les vibrations du filtre à onde acoustique de volume.

La présente invention s'applique à divers circuits devant émettre, recevoir ou filtrer une fréquence élevée, par exemple des fréquences de 0,9 et 2,4 GHz dans des circuits de téléphone portable, mais plus généralement toute fréquence de haute valeur, éventuellement supérieure à 10 GHz. Ainsi elle s'applique à de nombreux produits électroniques tels que des téléphones portables, des ordinateurs, des assistants personnels, des télécommandes, des baladeurs...

Pour atteindre tout ou partie de ces objets ainsi que d'autres, la présente invention prévoit un assemblage monolithique de composants électroniques comprenant un substrat, à un premier niveau au-dessus du substrat, au moins un résonateur à ondes acoustiques de volume, à un deuxième niveau au-dessus du résonateur, une couche semiconductrice monocristalline dans laquelle sont formés des composants semiconducteurs, et des évidements sous les parties de la couche semiconductrice disposées au-dessus des résonateurs.

Selon un mode de réalisation de la présente invention, le substrat est semiconducteur.

Selon un mode de réalisation de la présente invention, les résonateurs sont disposés au-dessus d'un ensemble de couches formant miroir de Bragg.

Selon un mode de réalisation de la présente invention, à chaque résonateur ou ensemble de résonateurs sont associées une électrode inférieure et une électrode supérieure.

Selon un mode de réalisation de la présente invention, les contacts avec lesdites électrodes supérieure et inférieure sont assurés par des vias descendant à partir de la face du composant disposée du côté de ladite couche semiconductrice monocristalline.

La présente invention prévoit aussi un procédé de fabrication d'un assemblage de composants comprenant d'une part des résonateurs à ondes acoustiques de volume, d'autre part des composants semiconducteurs tels que des transistors, formés à partir d'une première et d'une seconde plaquette, comprenant les étapes consistant à former une première plaquette comprenant un substrat, au moins un résonateur à ondes acoustiques de volume et une couche isolante supérieure comportant des ouvertures à des emplacements auxquels on veut établir des contacts avec des électrodes supérieure et inférieure, et à des emplacements disposés au-dessus des résonateurs ; former une deuxième plaquette contenant des composants semiconducteurs et ayant une face supérieure lisse, la face supérieure de la deuxième plaquette comprenant des ouvertures en regard des emplacements auxquels on souhaite former des contacts avec lesdites électrodes supérieure et inférieure ; et accoler la face supérieure de la première plaquette et la face supérieure de la deuxième plaquette.

Selon un mode de réalisation de la présente invention, la fabrication de la deuxième plaquette comprend les étapes consistant à former, sur une structure comprenant un substrat semiconducteur, une couche intermédiaire et une couche semiconductrice, divisée par des régions isolantes, des régions isolantes supplémentaires étant prévues aux emplacements qui, après assemblage, seront placés en regard des ouvertures dans la première plaquette au-dessus des zones de contact, former une couche isolante recouvrant les composants semiconducteurs et contenant les divers niveaux d'interconnexion, assembler ladite structure avec une plaquette poignée du côté de ladite couche isolante, araser le substrat initial, creuser des ouvertures en regard des régions isolantes supplémentaires.

Selon un mode de réalisation de la présente invention, la couche intermédiaire est une couche de silicium-germanium qui est oxydée après élimination du premier substrat.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est une vue en coupe d'une partie d'une plaquette semiconductrice sur laquelle est formée un filtre BAW selon un mode de réalisation de la présente invention ;
les figures 2 à 4 sont des vues en coupe successives d'une partie d'une plaquette semiconductrice portant divers composants semiconducteurs ;
la figure 5 représente l'assemblage des plaquettes des figures 1 et 4 ; et
la figure 6 représente une étape ultérieure de fabrication d'une structure assemblant des circuits intégrés classiques et un filtre BAW selon un mode de réalisation de la présente invention.

Par souci de clarté, de mêmes éléments ont été désignés par de mêmes références aux différentes figures et, de plus, comme cela est habituel dans la représentation des circuits intégrés, les éléments des diverses figures ne sont pas tracés à l'échelle.

### Description détaillée

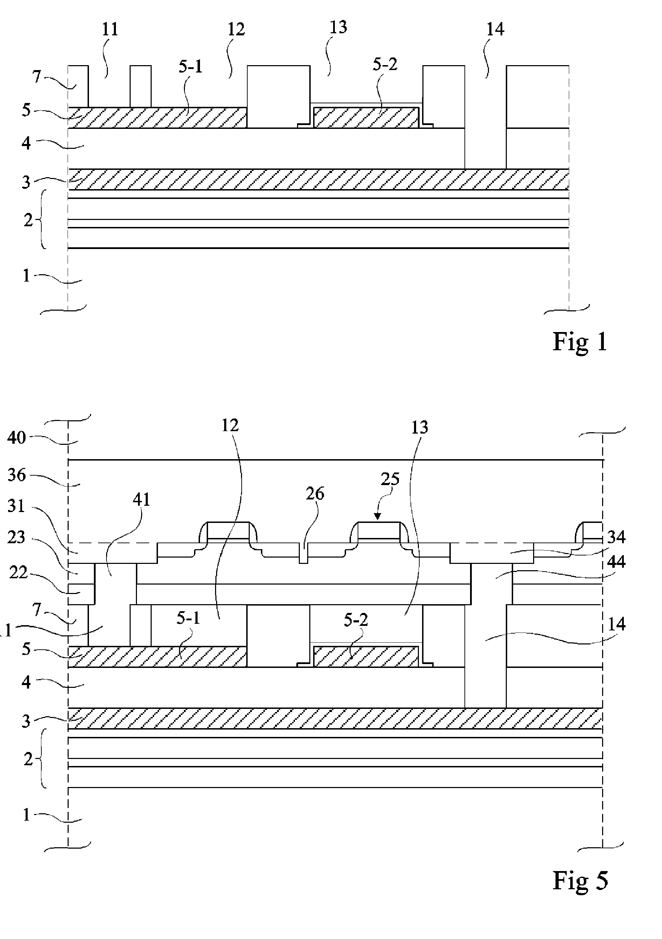

La figure 1 représente un filtre à ondes acoustiques de volume (BAW) formé sur une plaquette semiconductrice. Cette structure est formée sur un substrat 1 revêtu sur au moins une partie de sa surface d'un réflecteur de Bragg 2 comprenant un ensemble de couches d'indices différents, par exemple une alternance de couches de tungstène et d'oxyde de silicium ou une alternance de couches de nitrure de silicium et d'oxyde de silicium chargé au carbone (SiOC). Ce réflecteur, qui évite que les ondes acoustiques se propagent dans le substrat, est surmonté d'une couche conductrice 3 qui doit servir de première électrode pour le filtre BAW. Une mince couche isolante (non représentée), est insérée si nécessaire entre le réflecteur de Bragg et la couche conductrice 3. Ensuite, est déposée une couche piézoélectrique 4, par exemple du nitrure d'aluminium et, du côté de la face supérieure, est déposée une deuxième électrode 5. Les électrodes 3 et 5 sont par exemple en molybdène. On a représenté deux parties 5-1 et 5-2 de l'électrode supérieure au-dessus de la couche piézoélectrique. La partie 5-2 de l'électrode est revêtue d'une couche supplémentaire (on dit qu'elle est "chargée") afin de modifier la fréquence de résonance du matériau piézoélectrique situé en dessous. Ainsi, les deux parties 5-1 et 5-2 produisent des vibrations en volume à des fréquences différentes, ce qui élargit la plage de fréquence et permet au système de fonctionner en filtre.

Ceci ne constitue qu'un exemple de système à ondes acoustiques de volume. De façon connue, de nombreux autres matériaux et dispositions pourront être utilisés. D'autre part, la partie de résonateur peut ne constituer qu'une partie de la plaquette semiconductrice, d'autres éléments de nature différente étant disposés éventuellement à d'autres emplacements de la plaquette, par exemple des composants passifs tels que des condensateurs, des résistances et des inductances. On notera que, quelle que soit la réalisation des résonateurs BAW, il convient de laisser au-dessus des parties actives de ces résonateurs, c'est-à-dire au-dessus des parties 5-1 et 5-2 illustrées en figure 1, un vide pour ne pas amortir les vibrations.

Sur la plaquette ainsi formée, est déposée une couche isolante relativement épaisse 7 dans laquelle quatre ouvertures sont formées. Une ouverture 11 découvre la surface supérieure de la métallisation supérieure 5, une ouverture 12 découvre la surface supérieure de la partie de résonateur correspondant à l'électrode 5-1, une ouverture 13 découvre la surface supérieure de la partie de résonateur correspondant à l'électrode 5-2, et une ouverture 14 découvre la couche conductrice inférieure 3 du filtre BAW. Divers moyens pourront être prévus par l'homme de l'art pour accéder à l'électrode inférieure 3. Selon une réalisation préférée, la couche piézoélectrique est interrompue (ou éliminée par gravure) au niveau où on veut former l'ouverture 14, avant de déposer la couche isolante 7. Ainsi, l'ouverture 14 pourra être formée en même temps que les ouvertures 11, 12, 13.

Pour des raisons qui seront explicitées ci-après, la face supérieure de la couche isolante 7 est soigneusement polie avant de former les ouvertures 11, 12, 13, 14. D'autre part, on notera que ces ouvertures n'occupent en fait qu'une partie réduite en vue de dessus de la surface de la plaquette semiconductrice.

Ayant formé la plaquette décrite ci-dessus contenant notamment des composants BAW, on fabrique séparément une deuxième plaquette destinée à contenir des composants semiconducteurs classiques.

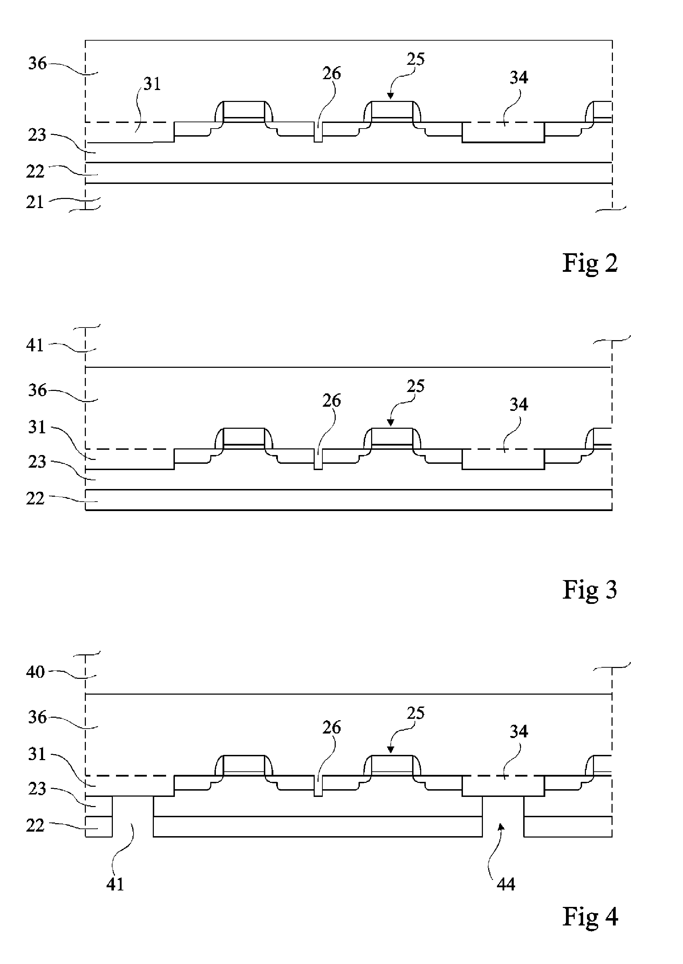

Un exemple de réalisation de fabrication de cette deuxième plaquette va être détaillé en relation avec les figures 2 à 4.

Comme l'illustre la figure 2, selon un mode de réalisation, la deuxième plaquette est formée à partir d'un substrat semiconducteur, par exemple une tranche de silicium monocristallin 21 sur laquelle sont formées successivement une couche intermédiaire 22 et une couche de silicium monocristallin 23. L'ensemble du substrat 21 et des couches 22 et 23 peut résulter de la technologie dite silicium sur isolant (SOI) auquel cas la couche intermédiaire est une couche d'oxyde de silicium. La structure peut aussi être formée en faisant croître par épitaxies successives sur le substrat de silicium 21 une couche de silicium-germanium (SiGe) et une couche de silicium, toutes deux monocristallines. Dans la couche de silicium monocristallin 23 sont formés de façon classique des composants semiconducteurs. Des transistors MOS 25 sont dessinés à titre d'exemple. Ces transistors MOS sont par exemple séparés les uns des autres par des régions isolantes 26 formées dans des évidements creusés dans le substrat. De telles régions d'isolement, couramment désignées dans la technique par le sigle STI (Shallow Trench Isolation ou isolement par tranchées peu profondes), sont bien connues et ne seront pas décrites en détail.

Selon un aspect de la présente invention, en même temps que l'on forme les régions isolantes 26 d'isolement entre composants, on forme des régions isolantes un peu plus étendues, désignées par les références 31 et 34, dont le rôle sera explicité ci-après. Ensuite, l'ensemble de la structure est revêtu d'une alternance de couches d'isolement et de métal destinées à assurer les connexions entre composants et à définir un circuit intégré de configuration choisie. Cet ensemble de couches est désigné de façon générale par la référence 36, la face supérieure de cet ensemble de couches correspondant à une couche isolante dont la surface est soigneusement aplanie et polie.

A titre d'exemple d'ordres de grandeur, le substrat de silicium 21 a une épaisseur de l'ordre de 700 µm pour une tranche d'un diamètre de 200 mm, la couche 22, dans le cas où il s'agit de SiGe, une épaisseur de l'ordre de 40 à 70 nm, la couche de silicium 23 une épaisseur de l'ordre de 20 à 100 nm, et l'ensemble de couches 36 une épaisseur de 1 à 2 µm.

Dans une étape suivante illustrée en figure 3, on "colle" sur la face supérieure de la couche 36 une poignée de silicium. De façon classique, on prévoit une plaquette de silicium 41 dont une face est soigneusement polie et oxydée et on applique la surface oxydée de la plaquette de silicium contre la face supérieure de la couche 36. Il en résulte un collage moléculaire des deux plaquettes. Ce collage peut être amélioré par des étapes thermiques appropriées de consolidation des liaisons Si-O. Une fois ce collage effectué, on élimine la plaquette de silicium initiale 21 jusqu'à la couche 22. Cette élimination peut par exemple être effectuée en deux temps. Dans un premier temps, on procède par un simple rodage et dans un deuxième temps, on procède à une attaque chimique sélective du silicium par rapport au matériau de la couche intermédiaire. Dans le cas où la couche intermédiaire est une couche de SiGe, on a une sélectivité d'attaque très importante pour certains produits comme le montre par exemple la publication "Control of the Selectivity between SiGe and Si in Isotropic Etching Process" publié dans Japanese Journal of Applied Physics, Part 1, V. 43, N 6B, juin 2004, PP 3964-3966.

Le résultat des étapes suivantes est illustré en figure 4. Tout d'abord, dans le cas où la couche intermédiaire n'est pas une couche d'oxyde de silicium, on oxyde cette couche pour en transformer au moins la surface en une couche de SiO₂. On notera que, si la couche intermédiaire était une couche de SiGe, la surface de SiO₂ obtenue sera particulièrement lisse et régulière. Ensuite, on creuse des ouvertures 41 et 44 dans l'ensemble de couches 22 et 23, jusqu'à atteindre les couches isolantes 31 et 34.

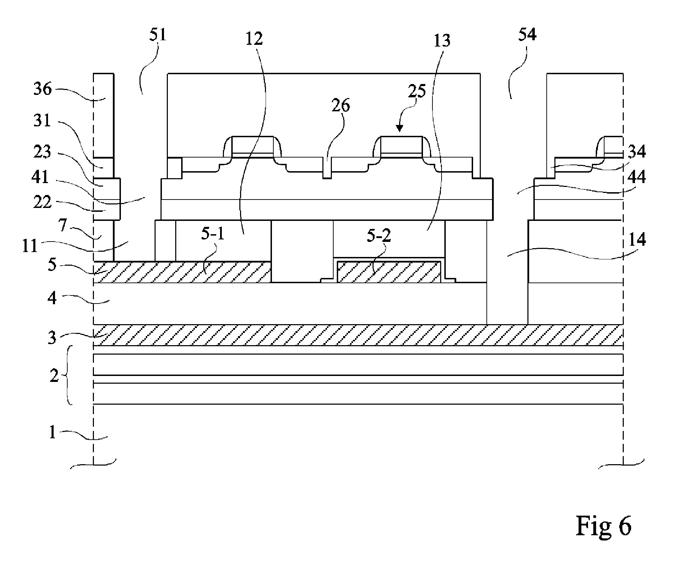

Ensuite, comme cela est illustré en figure 5, on assemble les plaquettes décrites respectivement en relation avec la figure 1 et en relation avec la figure 4. La face externe de la couche 7 de la figure 1 est mise en contact avec la face externe de la couche 22 de la figure 4, de façon à assurer un collage moléculaire entre ces deux couches. Les plaquettes sont assemblées de façon que la couche 22 ferme les ouvertures 12 et 13 et que les ouvertures 41 et 44 se trouvent en regard des ouvertures 11 et 14.

Grâce à cet assemblage, on notera qu'il existe bien un vide au-dessus des métallisations 5-1 et 5-2 des résonateurs décrits en relation avec la figure 1. Bien qu'on ait employé ici le terme "vide", on comprendra que l'intervalle concerné est effectivement en dépression ou est rempli d'un gaz choisi, selon les conditions dans lesquelles est réalisé l'assemblage des plaquettes des figures 1 et 4.

Dans des étapes ultérieures, on assure les connexions entre les divers dispositifs. Ainsi, comme le représente la figure 6, on commence par éliminer la plaquette supérieure 40 pour rendre apparente la surface supérieure de l'ensemble de couches 36. Ensuite, on creuse dans l'ensemble de couches 36 (on rappellera que cet ensemble de couches résulte du dépôt successif de couches d'isolant et de métal - toutefois, aux endroits où l'on réalise des ouvertures, on aura veillé à ce qu'il n'y ait que des couches d'isolant). On creuse donc des ouvertures 51 et 54 dans l'ensemble de couches 36 jusqu'à atteindre les couches 31 et 34 et la gravure est poursuivie jusqu'à percer ces couches pour déboucher dans les ouvertures 41-11 et 44-14 précédemment formées. On peut ensuite remplir ces ouvertures 51-41-11 et 54-44-14 d'un métal pour obtenir des vias permettant de contacter respectivement les électrodes supérieure 5 et inférieure 3 du résonateur BAW.

On formera ensuite de façon classique des ouvertures dans la partie supérieure de la couche 36 pour établir des contacts avec des vias ou portions de couches conductrices sous-jacents à la partie supérieure isolante de l'ensemble de couches 36.

On a ainsi obtenu un composant assemblant des circuits intégrés classiques et des résonateurs BAW.

Bien entendu, diverses variantes apparaîtront à l'homme de l'art notamment en ce qui concerne les types de composants pouvant être prévus dans le circuit intégré de la plaquette décrite en relation avec les figures 2 à 4. Notamment, on n'a mentionné que des transistors MOS. On pourrait réaliser en outre, ou à la place, des transistors bipolaires. De même, la structure de résonateur BAW a de nombreuses variantes. Ce résonateur pourrait être réalisé sur un substrat autre que du silicium, par exemple une céramique, du verre... D'autre part, on notera que l'on n'a représenté dans les diverses figures qu'une partie de l'étendue d'une plaquette, et que d'autres composants électroniques passifs ou actifs pourront être réalisés dans les parties non représentées.

On a représenté et décrit un assemblage comprenant un résonateur BAW surmonté d'un vide. La présente invention s'applique à tout autre composant devant être surmonté d'un vide, ce vide pouvant servir à un isolement mécanique, électrique, acoustique, magnétique..., par exemple un composant MEMS, une inductance, un commutateur RF.

## Revendications

1. Assemblage monolithique de composants électroniques comprenant :
un substrat semiconducteur (1),
à un premier niveau au-dessus du substrat, au moins un premier dispositif,
à un deuxième niveau au-dessus du premier niveau, une couche semiconductrice monocristalline (23) dans laquelle sont formés des composants semiconducteurs, et
des évidements (12, 13) sous les parties de la couche semiconductrice disposées au-dessus du premier dispositif.

2. Assemblage selon la revendication 1, dans lequel le premier dispositif est un résonateur à ondes acoustiques de volume (2-5).

3. Assemblage selon la revendication 1, dans lequel le substrat est semiconducteur.

4. Assemblage selon la revendication 2, dans lequel le résonateur est disposé au-dessus d'un ensemble de couches (2) formant miroir de Bragg.

5. Assemblage selon la revendication 2, dans lequel à chaque résonateur ou ensemble de résonateurs sont associées une électrode inférieure (3) et une électrode supérieure (5).

6. Assemblage selon la revendication 5, dans lequel les contacts avec lesdites électrodes supérieure et inférieure sont assurés par des vias descendant à partir de la face du composant disposée du côté de ladite couche semiconductrice monocristalline.

7. Produit électronique, tel que téléphone portable, ordinateur, assistant personnel, télécommande, baladeur... comprenant un assemblage selon la revendication 2.

8. Procédé de fabrication d'un assemblage de composants comprenant d'une part des résonateurs à ondes acoustiques de volume, d'autre part des composants semiconducteurs tels que des transistors, formés à partir d'une première et d'une seconde plaquette, comprenant les étapes suivantes :
former une première plaquette comprenant un substrat (1), au moins un résonateur à ondes acoustiques de volume (3, 4, 5) et une couche isolante supérieure (7) comportant des ouvertures à des emplacements (11, 14) auxquels on veut établir des contacts avec des électrodes supérieure et inférieure, et à des emplacements (12, 13) disposés au-dessus des résonateurs ;
former une deuxième plaquette contenant des composants semiconducteurs et ayant une face supérieure lisse, la face supérieure de la deuxième plaquette comprenant des ouvertures en regard des emplacements auxquels on souhaite former des contacts avec lesdites électrodes supérieure et inférieure ; et
accoler la face supérieure de la première plaquette et la face supérieure de la deuxième plaquette.

9. Procédé selon la revendication 8, dans lequel la fabrication de la deuxième plaquette comprend les étapes suivantes :
former, sur une structure comprenant un substrat semiconducteur (21), une couche intermédiaire (22) et une couche semiconductrice (23), divisée par des régions isolantes (26), des régions isolantes supplémentaires (31, 34) étant prévues aux emplacements qui, après assemblage, seront placés en regard des ouvertures dans la première plaquette au-dessus des zones de contact,
former une couche isolante (36) recouvrant les composants semiconducteurs et contenant les divers niveaux d'interconnexion,
assembler ladite structure avec une plaquette poignée (41) du côté de ladite couche isolante (36),
araser le substrat (21) initial,
creuser des ouvertures (41, 44) en regard des régions isolantes supplémentaires (31, 34).

10. Procédé selon la revendication 9, dans lequel la couche intermédiaire est une couche de silicium-germanium qui est oxydée après élimination du premier substrat (21).
